# EUROPEAN PATENT APPLICATION

(11) **EP 4 648 270 A1**
(43) Date of publication of application: **12.11.2025**
(21) Application number: 23914956.0
(22) Date of filing: 04.12.2023
(51) Int. Cl.: H02M 7/00, H05K 7/20, H05K 9/00, H01F 27/08, H01F 27/02

(54) **SUBMODULE FOR SINGLE PACKAGING TYPE SEMICONDUCTOR TRANSFORMER WITH EXCELLENT INSULATION PERFORMANCE**

(30) Priority: 02.01.2023 KR 20230000340
(71) Applicant: Hyosung Heavy Industries Corporation, Seoul 04144 (KR)
(72) Inventor: RYU, Gwang Hyeon, Seoul 04788 (KR); KIM, Sung Joo, Goyang-si, Gyeonggi-do 10218 (KR); JEONG, Byung Hwan, Gwacheon-si, Gyeonggi-do 13835 (KR)
(74) Representative: Viering, Jentschura & Partner mbB Patent- und Rechtsanwälte
(86) International application number: PCT/KR2023/019783
(87) International publication number: WO 2024/147493

(57) **Abstract**

The present invention relates to a submodule for a single packaging type semiconductor transformer with excellent insulation performance in which insulation performance is improved by securing a separation distance between a high-voltage part and a low-voltage part in a semiconductor transformer, cooling paths of the high-voltage part and the low-voltage part are individually provided to secure insulation performance, a water-cooled heat sink plate cools heat generated in a semiconductor element and a switching module, electrical radiation noise is also reduced, and the introduction of the electrical radiation noise is suppressed. A submodule for a single packaging type semiconductor transformer with excellent insulation performance of the present invention includes a high-voltage part which converts high-voltage and low frequency AC power into high frequency AC power, a medium frequency transformer which converts the high-voltage AC power into low-voltage AC power, and a low-voltage part which converts the low-voltage AC power into low-voltage DC power.

## Description

### [Technical Field]

The present invention relates to a submodule for a single packaging type semiconductor transformer with excellent insulation performance, and more specifically, to improving insulation performance between a high-voltage part and a low-voltage part in a semiconductor transformer.

The present invention relates to a submodule for a single packaging type semiconductor transformer with excellent insulation performance in which insulation performance between a high-voltage part and a low-voltage part is secured using cooling water in a submodule for a semiconductor transformer, a water-cooled heat sink plate cools heat, electrical radiation noise is also reduced, and the introduction of the electrical radiation noise is suppressed.

### [Background Art]

Generally, in order to charge a vehicle battery of an electric vehicle, a transformer drops a voltage of 22.9 kV at 60 Hz and converts the voltage into a DC voltage of a predetermined magnitude. Such a transformer and an alternating current (AC)/direct current (DC) converter are components which are heavy and require weight reduction.

Particularly, since a main transformer operates at a low frequency of 60 Hz, and such a low frequency transformer is heavy and has a large volume, power density is relatively low.

Many studies for reducing the weight of a transformer and an AC/DC converter operating at a commercial frequency have been conducted to improve the above problems, and one of the studies is to increase the operating frequency of a transformer to a frequency ranging from several kHz to several tens kHz, which is relatively higher than a frequency of 60 Hz, using a semiconductor element to reduce the volume and weight of the transformer.

An apparatus which converts low frequency and high-voltage input power into high-frequency power using a semiconductor element and converts the high-frequency power into low DC voltage using a medium frequency transformer (MFT) as described above is called a solid-state transformer (SST) or intelligent transformer, and the importance is emerging due to advantages of system size reduction, power quality compensation, and the possibility of a unitary power factor when compared to conventional low frequency transformers.

Meanwhile, in the case of a conventional low frequency transformer, when a high-voltage of 22.9 kV is applied, since an insulation problem may occur between a primary winding and a secondary winding, the primary winding and the secondary winding are spaced apart from each other, an insulating structure is disposed therebetween, and insulating oil is used for insulation between the primary winding and the secondary winding, and thus there is a disadvantage that the weight and volume of a commercial frequency transformer are increased.

Such an insulation problem occurs equally when the conventional commercial frequency transformer is replaced with a semiconductor transformer. That is, since a conventional transformer structure is applied to an MFT used in the semiconductor transformer without being changed, the same problem occurs, and efforts to solve the insulation problem between components of a high-voltage part and a low-voltage part have been continuously made.

As an example, in Korean Laid-open Patent Publication No. 10-2020-0048376, a submodule of a modular multilevel converter, which includes a first housing in which a capacitor is installed and a second housing in which the remaining components including an insulated gate bipolar mode transistor (IGBT) switch are installed, and in which the first housing is detachably installed on a side surface of the second housing in a hot swap manner to more easily perform maintenance including replacement of the submodule capacitor and also secure the sufficient dielectric strength between the submodule capacitor and the submodule control device, is proposed.

However, even in this case, there is a disadvantage that dielectric strength is not sufficient because a sufficient separation distance between a high-voltage part and a low-voltage part is not secured, and in addition, there is a problem of being directly exposed to electrical radiation noise generated in the high-voltage part and the low-voltage part.

### [Technical Problem]

The present invention is directed to providing a submodule for a single packaging type semiconductor transformer with excellent insulation performance in which insulation performance is improved by securing a separation distance between a high-voltage part and a low-voltage part in a semiconductor transformer.

The present invention is directed to providing a submodule for a single packaging type semiconductor transformer with excellent insulation performance in which cooling paths of a high-voltage part and a low-voltage part in a submodule for a semiconductor transformer are individually provided to secure insulation performance, a water-cooled heat sink plate cools heat generated in a semiconductor element and a switching module, electrical radiation noise is also reduced, and the introduction of the electrical radiation noise is suppressed.

### [Technical Solution]

In accordance with one aspect of the present invention, there is provided a submodule for a single packaging type semiconductor transformer with excellent insulation performance including a high-voltage part which matches high-voltage and low frequency alternating current (AC) power and converts the high-voltage and low frequency AC power into high-voltage AC power, a medium frequency transformer which converts the high-voltage AC power into low-voltage AC power, and a low-voltage part which converts the low-voltage AC power into low-voltage direct current (DC) power.

In this case, in the medium frequency transformer, a partition wall with the high-voltage part and a partition wall with the low-voltage part may be removed.

In addition, a size of the medium frequency transformer may be changed according to voltages used in the high-voltage part and the low-voltage part or to a potential difference between the high-voltage part and the low-voltage part, and the medium frequency transformer may be provided between the high-voltage part and the low-voltage part.

In this case, as the medium frequency transformer may have a structure in which a size of the medium frequency transformer is easily changed according to a physical constraint such as a size of a transformer, the size of the medium frequency transformer may be changed so that the medium frequency transformer may be provided between the high-voltage part and the low-voltage part.

In addition, the medium frequency transformer may be surrounded by an outer case formed of epoxy glass.

In this case, a vent hole for discharging heat generated in the transformer may be formed in a side cover of the medium frequency transformer.

In addition, the vent hole may not be formed in a portion of the side cover of the medium frequency transformer corresponding to a side surface of the high-voltage part.

Meanwhile, in the high-voltage part and the low-voltage part, a high-voltage part cooling path for entering and exiting the high-voltage part and a low-voltage part cooling path for entering and exiting the low-voltage part may be provided to be separated from each other.

In addition, the high-voltage part cooling path and the low-voltage part cooling path may be provided so as not to intersect each other.

In addition, a cooling water may be supplied to the high-voltage part and the low-voltage part using one cooling pump.

Meanwhile, each of the high-voltage part and the low-voltage part may include a heat sink plate for cooling heat generated in the high-voltage part and the low-voltage part, and the heat sink plate may be water-cooled by receiving the cooling water.

In this case, the heat sink plate may cool the heat generated in a semiconductor element and a switching module in the high-voltage part and the low-voltage part.

In addition, the heat sink plate may be formed to function as a shielding plate for suppressing radiation noise generated in the switching module from being introduced into a control unit and a gate driving device, which are vulnerable to noise, and for reducing electrical radiation noise.

In addition, the heat sink plate may be formed such that signal lines enter left and right side surfaces of the heat sink plate, and signal paths between components located at front and rear surfaces of the heat sink plate are minimized to reduce exposure to radiation noise generated in the switching module.

### [Advantageous Effects]

A submodule for a single packaging type semiconductor transformer with excellent insulation performance according to the present invention has an advantage of improving insulation performance by securing a separation distance between a high-voltage part and a low-voltage part in a semiconductor transformer.

In addition, the submodule for a single packaging type semiconductor transformer with excellent insulation performance according to the present invention has advantages that insulation performance between a high-voltage part and a low-voltage part in a submodule for a semiconductor transformer is secured using individual cooling paths, a water-cooled heat sink plate cools heat generated in a semiconductor element and a switching module, electrical radiation noise is also reduced, and the introduction of the electrical radiation noise is suppressed.

### [Description of Drawings]

FIG. 1 is a view illustrating a submodule for a single packaging type semiconductor transformer with excellent insulation performance according to one embodiment of the present invention.
FIG. 2 is a view illustrating in detail a configuration of a high-voltage part, a medium frequency transformer, and a low-voltage part of FIG. 1.
FIG. 3 is a view showing in detail an arrangement of heat sink plates in the high-voltage part and the low-voltage part of FIG. 1, wherein FIG. 3A is a front view thereof, and FIG. 3B is a rear view thereof.

### [Modes of the Invention]

Hereinafter, specific embodiments for implementing the present invention will be described with reference to the accompanying drawings.

Although terms such as "first," "second," and the like may be used to describe various components, the components are not limited by these terms. These terms are only used to distinguish one component from another component. For example, a first component may be named a second component, and similarly, a second component may also be named a first component without departing from the scope of the present invention.

When a first element is referred to as being "connected" or "coupled" to a second element, it will be understood that the first element may be directly connected or coupled to the second element, or a third element may be present therebetween.

Terms used in the present specification are for the purpose of describing particular embodiments only and are not intended to limit the present invention. The singular forms include the plural forms, unless the context clearly indicates otherwise.

It may be understood that terms "comprise," "include," and the like herein specify the presence of stated features, numbers, steps, operations, elements, components, or combinations thereof but do not preclude the presence or addition of one or more other features, numbers, steps, operations, elements, components, or combinations thereof.

In addition, the shapes and sizes of elements in the drawings may be exaggerated for clearer description.

Hereinafter, a submodule for a single packaging type semiconductor transformer with excellent insulation performance according to the present invention will be described in detail with reference to the accompanying drawings.

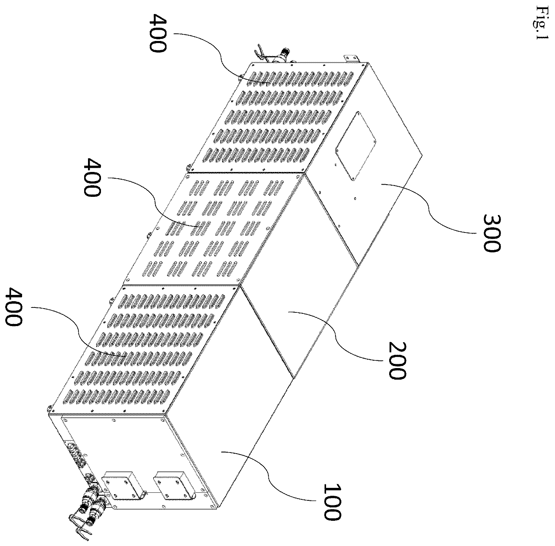

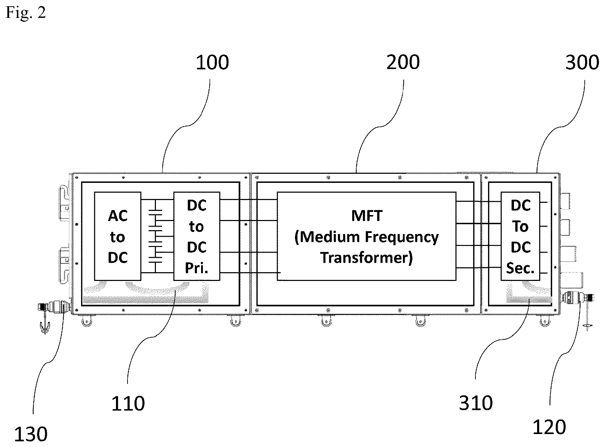

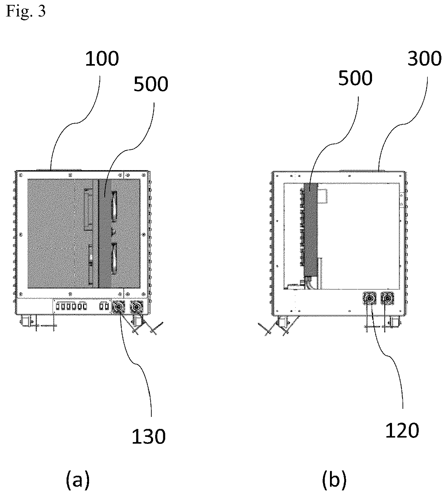

FIG. 1 is a view illustrating a submodule for a single packaging type semiconductor transformer with excellent insulation performance according to one embodiment of the present invention, and FIGS. 2 and 3 are detailed views for describing FIG. 1 in detail.

Hereinafter, referring to FIGS. 1 to 3, the submodule for a single packaging type semiconductor transformer with excellent insulation performance according to one embodiment of the present invention will be described.

First, referring to FIG. 1, the submodule for a single packaging type semiconductor transformer with excellent insulation performance according to one embodiment of the present invention includes a high-voltage part 100 which converts high-voltage and low frequency alternating current (AC) power into high-voltage AC power, a medium frequency transformer (MFT) 200 which converts the high-voltage AC power into low-voltage AC power, and a low-voltage part 300 which converts the low-voltage AC power into low-voltage direct current (DC) power.

Generally, a semiconductor transformer whose input power is a system voltage of AC 22.9kV needs a submodule structure design that takes into account mechanical/electrical insulation for securing high insulation performance.

The submodule for a semiconductor transformer according to the present invention is configured in a form in which the high-voltage part 100 and the low-voltage part 300 are insulated from each other with the MFT 200 as a center and configured with a packaging structure in which cases of the high-voltage part 100, the MFT 200, and the low-voltage part 300 are sequentially connected.

In this case, a size of the MFT 200 is changed according to voltages used in the high-voltage part 100 and the low-voltage part 300 or to a potential difference between the high-voltage part 100 and the low-voltage part 300, and then the MFT 200 is applied between the high-voltage part 100 and the low-voltage part 300. In addition, as the MFT 200 has a structure in which the size of the MFT 200 is easily changed according to a physical constraint such as a transformer, the size of the MFT 200 may be changed, and the MFT 200 may be provided between the high-voltage part 100 and the low-voltage part 300.

That is, the present invention has an advantage that the size of the MFT 200 can be adjusted to easily increase a separation distance between the high-voltage part 100 and the low-voltage part 300 to improve the insulation performance by securing the separation distance and a creepage distance in air.

In this case, depending on the voltages used in the high-voltage part 100 and the low-voltage part 300, when the voltage used in the high-voltage part 100 is relatively greater than the voltage used in the low-voltage part 300, the size of the MFT 200 may be changed to be increased, and as the size of the transformer is smaller, the size of the MFT 200 is physically decreased to change the separation distance between the high-voltage part 100 and the MFT 200 to be decreased.

In addition, outer cases of the high-voltage part 100, the MFT 200, and the low-voltage part 300 of the present invention include vent holes 400, thereby discharging heat generated therein to the outside.

In this case, according to embodiments, a side cover of the MFT 200 also includes vent holes, but the vent holes are not provided in a portion of the side cover of the MFT 200 corresponding to a side surface of the high-voltage part 100. As described above, as the vent holes 400 are not provided in the portion of the side cover of the MFT 200 corresponding to the side surface of the high-voltage part 100, there is an effect of further improving the insulation performance between the high-voltage part 100 and the low-voltage part 300.

As described above, in the submodule for a single packaging type semiconductor transformer with excellent insulation performance according to the present invention, since the separation distance between the high-voltage part 100 and the low-voltage part 300 may be easily changed according to the voltages used in the high-voltage part 100 and the low-voltage part 300 and the size of the transformer, there are advantages that the insulation performance between the high-voltage part 100 and the low-voltage part 300 can be maintained, and an optimum size can also be provided.

FIG. 2 is a view illustrating in detail a configuration of the high-voltage part 100, the MFT 200, and the low-voltage part 300 of FIG. 1.

As shown in FIG. 2, in the MFT 200 of the present invention, a partition wall with the high-voltage part 100 and a partition wall with the low-voltage part 300 are removed.

In the present invention, as the partition walls of the MFT 200 with the high-voltage part 100 and the low-voltage part 300 are removed, there are effects of significantly decreasing the overall weight and size of the submodule and improving insulation performance.

By removing the partition walls and rearranging components, a distance between the high-voltage part 100 and the MFT 200 may be decreased to about 20 mm, and a distance between the MFT 200 and the low-voltage part 300 may be decreased to about 20 mm to minimize the size of the submodule.

In addition, test results showed that before the partition walls were removed, the insulation performance was 200 pC or less at 25 kV, whereas after the partition walls were removed, the insulation performance was the same as that before the partition walls were removed at 48 kV, so that the present invention has an effect of improving insulation performance by removing the partition walls.

In addition, in the present invention, the MFT 200 is formed with a structure surrounded by the outer case formed of epoxy glass which is a material with excellent insulation strength and flame-retardant performance, and accordingly, the present invention secures the separation distance and the creepage distance between the high-voltage part 100 and the low-voltage part 300 in air and improves insulation performance.

Meanwhile, in the present invention, the high-voltage part 100 and the low-voltage part 300 include separate cooling paths for cooling water for cooling the internal components of the high-voltage part 100 and the low-voltage part 300.

That is, in the cooling paths of the present invention, a high-voltage part cooling path 110 for entering and exiting the high-voltage part 100 and a low-voltage part cooling path 310 for entering and exiting the low-voltage part 300 are provided to be separated, and the high-voltage part cooling path 110 and the low-voltage part cooling path 310 are provided so as not to intersect each other.

This is because, when the high-voltage part cooling path 110 and the low-voltage part cooling path 310 intersect, electromagnetic waves of the high-voltage part 100 present in the cooling water in the high-voltage part cooling path 110 is induced to the cooling water in the low-voltage part cooling path 310, and the electromagnetic waves may eventually affect the low-voltage part 300, and the opposite case is also true, so that electromagnetic waves of the low-voltage part 300 may affect the high-voltage part 100.

Accordingly, in the present invention, as the high-voltage part cooling path 110 and the low-voltage part cooling path 310 are separated from each other and do not intersect, the insulation performance between the high-voltage part 100 and the low-voltage part 300 can be further improved.

Meanwhile, the cooling water may be supplied to the high-voltage part 100 and the low-voltage part 300 using one cooling pump which is not illustrated, and in this case, since a separate cooling pump is not used for each cooling path, installation costs can be reduced.

FIG. 3 is a view showing in detail an arrangement of heat sink plates in the high-voltage part 100 and the low-voltage part 300 of FIG. 1, wherein FIG. 3A is a front view thereof, and FIG. 3B is a rear view thereof.

As can be seen in FIG. 3, in the present invention, the high-voltage part 100 and the low-voltage part 300 may include heat sink plates 500 for cooling the heat generated in the high-voltage part 100 and the low-voltage part 300, and components may be assembled to front surfaces and rear surfaces of the corresponding heat sink plates 500.

That is, components for heat dissipation are directly assembled and installed on the front and rear surfaces of the heat sink plates 500, and components which are not related to heat dissipation may be installed on the heat sink plates 500 with predetermined distances therebetween. As an example, in the present invention, the heat sink plates 500 may cool the heat generated in a semiconductor element and a switching module.

In this case, the heat sink plates 500 may be water-cooled by receiving cooling water for heat dissipation, and thus, the high-voltage part 100 and the low-voltage part 300 can be miniaturized.

Meanwhile, the switching module is used to switch AC or DC power to that at high-frequency in the high-voltage part 100 and the low-voltage part 300 to supply the switched AC or DC power, and electrical radiation noise is generated during the switching operation.

In the present invention, the heat sink plates 500 may be formed to function as shielding plates for reducing the electrical radiation noise, and thus, the radiation noise generated in the switching module can be suppressed from being introduced into a control unit and a gate driving device which are vulnerable to noise.

In addition, the heat sink plates 500 of the present invention may be configured such that signal lines enter left and right side surfaces of the heat sink plates 500, and thus in the present invention, as signal paths between components located at front and rear surfaces of the heat sink plates are minimized, exposure to the radiation noise generated in the switching module can be reduced.

As described above, in the submodule for a single packaging type semiconductor transformer with excellent insulation performance according to the present invention, insulation performance can be improved by securing the separation distance between the high-voltage part and the low-voltage part in the semiconductor transformer, the cooling paths of the high-voltage part and the low-voltage part can be individually provided in the submodule for a semiconductor transformer to secure insulation performance, the water-cooled heat sink plates can cool the heat generated in the semiconductor element and the switching module, electrical radiation noise can be reduced, and the introduction of the electrical radiation noise can be suppressed.

The above description includes examples of one or more embodiments. However, those skilled in the art will recognize that all possible combinations of components or methods for the purpose of describing the above-described embodiments may not be described, many combinations may be added to the embodiments, and different embodiments may be substituted. Accordingly, the described embodiments include all alternatives, modifications, and changes within the spirit and scope of the appended claims.

### [Industrial Applicability]

The present invention relates to a submodule for a single packaging type semiconductor transformer with excellent insulation performance and can be used in the semiconductor transformer field.

## Claims

1. A submodule for a single packaging type semiconductor transformer with excellent insulation performance comprising:
a high-voltage part which matches high-voltage and low frequency alternating current (AC) power and converts the high-voltage and low frequency AC power into high-voltage AC power;
a medium frequency transformer which converts the high-voltage AC power into low-voltage AC power; and
a low-voltage part which converts the low-voltage AC power into low-voltage direct current (DC) power.

2. The submodule of claim 1, wherein, in the medium frequency transformer, a partition wall with the high-voltage part and a partition wall with the low-voltage part are removed.

3. The submodule of claim 1, wherein
a size of the medium frequency transformer is changed according to voltages used in the high-voltage part and the low-voltage part or according to a potential difference between the high-voltage part and the low-voltage part, and
the medium frequency transformer is provided between the high-voltage part and the low-voltage part.

4. The submodule of claim 1, wherein,
as the medium frequency transformer has a structure in which a size of the medium frequency transformer is easily changed according to a physical constraint such as a transformer used in the medium frequency transformer, the size of the medium frequency transformer is changed so that the medium frequency transformer is provided between the high-voltage part and the low-voltage part.

5. The submodule of claim 1, wherein the medium frequency transformer is surrounded by an outer case formed of epoxy glass.

6. The submodule of claim 5, wherein a vent hole is formed in a side cover of the medium frequency transformer.

7. The submodule of claim 6, wherein the vent hole is not formed in a portion of the side cover of the medium frequency transformer corresponding to a side surface of the high-voltage part.

8. The submodule of claim 1, wherein, in the high-voltage part and the low-voltage part, a high-voltage part cooling path for entering and exiting the high-voltage part and a low-voltage part cooling path for entering and exiting the low-voltage part are provided to be separated from each other.

9. The submodule of claim 8, wherein the high-voltage part cooling path and the low-voltage part cooling path are provided so as not to intersect each other.

10. The submodule of claim 8, wherein a cooling water is supplied to the high-voltage part and the low-voltage part using one cooling pump.

11. The submodule of claim 1, wherein each of the high-voltage part and the low-voltage part includes a heat sink plate for cooling heat generated in the high-voltage part and the low-voltage part, and the heat sink plate is water-cooled by receiving the cooling water.

12. The submodule of claim 11, wherein the heat sink plate cools heat generated in a semiconductor element and a switching module in the high-voltage part and the low-voltage part.

13. The submodule of claim 12, wherein the heat sink plate is formed to function as a shielding plate for suppressing radiation noise generated in the switching module from being introduced into a control unit and a gate driving device, which are vulnerable to noise, and for reducing electrical radiation noise.

14. The submodule of claim 11, wherein the heat sink plate is configured such that signal lines enter left and right side surfaces of the heat sink plate, and signal paths between components located at front and rear surfaces of the heat sink plate are minimized to reduce exposure to radiation noise generated in the switching module.
